# EUROPEAN PATENT APPLICATION

(11) **EP 4 465 342 A1**
(43) Date of publication of application: **20.11.2024**
(21) Application number: 22920420.1
(22) Date of filing: 27.10.2022
(51) Int. Cl.: H01L 21/301, B23K 26/03, B23K 26/08, B23K 26/10, B23K 26/38

(54) **PROCESSING DEVICE AND METHOD FOR MANUFACTURING PROCESSED ARTICLE**

(30) Priority: 13.01.2022 JP 2022003791
(71) Applicant: Towa Corporation, Kyoto-shi, Kyoto 601-8105 (JP)
(72) Inventor: OKAMOTO, Jun, Kyoto-shi, Kyoto 601-8105 (JP)
(74) Representative: Müller Hoffmann & Partner
(86) International application number: PCT/JP2022/040146
(87) International publication number: WO 2023/135898

(57) **Abstract**

The present invention simplifies a machining apparatus and improves the productivity thereof, and comprises a machining table 2A, 2B provided on one surface thereof with a plurality of suction holes 2h capable of holding a sealed substrate W by suction, and that has a plurality of through openings 2T which penetrate from the one surface 2x to another surface 2y; a machining mechanism 4 that machines the sealed substrate W held by suction to the machining table 2A, 2B, and a storage mechanism 211(23) that directly stores the sealed substrate W machined by the machining mechanism 4 to a storage member 21(24).

## Description

### Technical Field

The present invention relates to a machining apparatus and a method for manufacturing a machined product.

### Background Art

Conventionally, as shown in Patent Literature 1, an electronic component manufacturing device has been considered in which objects to be cut are received by a conveying mechanism from a cutting stage after being cut, and are then stored in a storage box. Also, as shown in Patent Literature 2, a cutting apparatus has been considered in which objects to be cut are sequentially received by a plurality of mechanisms from the cutting stage after being cut, and are then stored onto an affixing member.

### Prior Art Literature

### Patent Literature

Patent Literature 1: Japanese Patent Application Publication No. 2015-88558
Patent Literature 2: Japanese Patent Application Publication No. 2018-174191

### Summary of the Invention

### Problem to be Solved by the Invention

However, in both of these devices, a conveying mechanism is necessary to convey the object to be cut from the cutting table to the storage box or the affixing member after being cut, which causes the configuration of the device to be complicated. Also, transfer between the cutting table and the storage box or the affixing member takes time, limiting improvements in productivity.

The present invention was developed with the above issues in mind, and its object is to simplify and improve the productivity of a machining apparatus.

### Means of Solving the Problem

That is, the machining apparatus according to the present invention is characterized in including a machining table provided on one surface thereof with a plurality of suction holes capable of holding a machining target object by suction, and that has a plurality of through openings which penetrate from the one surface to another surface; a machining mechanism that machines the machining target object held by suction to the machining table, and a storage mechanism that directly stores the machined machining target object from the machining table to a storage member.

### Effect of the Invention

According to the present invention configured in this way, since the machined machining target object is directly stored from the machining table to the storage member, the machining apparatus can be simplified and its productivity improved.

### Brief Description of the Drawings

FIG 1: A plan view showing an example of machining target objects (sealed substrates).
FIG 2: A figure schematically showing a configuration of a cutting apparatus (bulk storage) according to an embodiment of the present invention.
FIG 3: A perspective view showing a cutting table and a table inversion mechanism of the same embodiment.
FIG 4: A cross-sectional view through suction holes in the cutting table and the table inversion mechanism of the same embodiment.
FIG 5: A plan view showing the positional relationship between through openings and the suction holes/suction flow path in the same embodiment.
FIG 6: Enlarged exploded perspective views of portions of the cutting table of the same embodiment.
FIG 7: The following views of the cutting table of the same embodiment: (a) a partial enlarged cross-sectional view orthogonal to the scanning direction of the laser light, and (b) a partial enlarged cross-sectional view along the scanning direction of the laser light.
FIG 8: A schematic diagram showing a procedure of laser cutting and machining scrap removal of the same embodiment.
FIG 9: A schematic diagram of the imaging direction of an inspection camera of the same embodiment.
FIG 10: A schematic diagram showing a procedure of imaging by the inspection camera and machining scrap re-removal of the same embodiment.
FIG 11: A schematic diagram showing a procedure of unwanted product removal of the same embodiment.
FIG 12: A schematic diagram showing a procedure of bulk storage of the same embodiment.
FIG 13: A figure schematically showing a configuration of a cutting apparatus (ring storage) according to a variation embodiment.
FIG 14: The following views, schematically showing a configuration of an affixing member: (a) a plan view, (b) a cross-sectional view, and (c) a partial enlarged cross-sectional view.
FIG 15: A schematic diagram showing a procedure of ring storage of the variation embodiment.

### Means for Carrying Out the Invention

The present invention will now be described in more detail with examples. However, the present invention is not limited to the explanation below.

That is, as mentioned above, the machining apparatus according to the present invention is characterized in including a machining table provided on one surface thereof with a plurality of suction holes capable of holding a machining target object by suction, and that has a plurality of through openings which penetrate from the one surface to another surface; a machining mechanism that machines the machining target object held by suction to the machining table, and a storage mechanism that directly stores the machined machining target object from the machining table to a storage member. Here, to `directly store' an object means to store it into or onto a storage member without first conveying it from the machining table to another table or stage.

In this machining apparatus, the machined machining target object is directly stored from the machining table to the storage member, and therefore there is no need to separately convey the machined machining target object to the storage member, allowing the machining apparatus to be simplified and productivity to be improved. The footprint of the machining apparatus can also be reduced thanks to being simplified.

It is preferable that machining table is able to be inverted front to back.

With this configuration, it is possible to machine the machining target object from both surfaces by inverting front to back the machining table which holds the machining target object by suction, thereby reducing machining time and improving productivity.

Furthermore, because the machining table is inverted front to back (top to bottom) while maintaining a state in which the machining target object is held, if the amount of position shift which occurs when the machining table is inverted front to back is measured once in advance, the position after inversion can be corrected via calculation, and there is no need to perform alignment (position adjustment) again for each inversion. Therefore, alignment (position adjustment) of the machining mechanism with respect to the machining target object only needs to be performed once after the machining target object is held by suction, which allows machining time to be reduced and productivity to be improved.

In order to store the machined machining target object in the storage box in a discrete state (also called `bulk storage'), it is preferable that the storage mechanism includes a storage box that stores the machined machining target object that falls from the machining table that has been inverted front to back. Here, in order to position the storage box below the machining table, the machining table and the storage box are moved relative to each other.

In order to store the machined machining target object by affixing it to an affixing member with an adhesive surface (also called `ring storage'), it is preferable that the storage mechanism causes an adhesive surface of an affixing member to contact the machined machining target object, which is on the machining table, and stores it onto the affixing member. Here, in order to position the affixing member above the machining table, the machining table and the affixing member are moved relative to each other.

When the machined machining target object is directly stored from the machining table to the storage member, the machined machining target object may stick firmly to the machining table and not come off, and it may not be possible to reliably store it to the storage member. As a suitable solution to this problem, it is preferable that the storage mechanism includes a pushing member that pushes the machined machining target object from one of the through openings and separates it from the machining table.

In order to determine if the machined machining target object is of good quality or is a defective product, it is preferable that the machining apparatus of the present invention further include an inspection unit that inspects the machined machining target object held by suction to the machining table.

In order to set apart defective products from other machined machining target objects, it is preferable that the machining apparatus of the present invention include a defective product removal mechanism that removes the machined machining target object, which has been determined to be a defective product by the inspection of the inspection unit, from the machining table before it is stored to the storage member.

Since this configuration is such that defective products are removed from the machining table, the machining apparatus can be simplified and the productivity thereof improved compared to configurations in which defective products are removed after they have been transferred to another table.

A preferable specific embodiment of the machining mechanism cuts by irradiating laser light onto the machining target object.

The machining apparatus of the present invention is preferable one wherein the machining table holding the machining target object by suction is inverted front to back and cutting is performed by irradiating laser light onto both surfaces of the machining target object.

With this configuration, when cutting by irradiating laser light onto the machining target object, the laser light passes through the through openings and it is possible to prevent laser light from hitting the machining table. As a result, it is possible to suppress damage to the machining table due to irradiation by laser light, as well as contaminants (impurities and foreign matter) adhering to the machining target object as a consequence thereof, and it is possible to reduce constraints on laser machining conditions meant to prevent damage to the machining table. The ability to reduce constraints on laser machining conditions allows the use of higher pulse energy and average power, thereby reducing machining time and increasing productivity.

Since the laser light passes through the through opening, the laser light is prevented from being reflected by the machining table and irradiated onto the machining target object, and damage to the machining target object by the laser light reflected by the machining table can be suppressed.

A method for manufacturing a machined product that manufactures the machined product using the machining apparatus described above is also an aspect of the present invention.

As a specific aspect of the method for manufacturing the machined product, it is preferable to include a cutting process wherein the machining table holding the machining target object by suction is inverted front to back, and the machining target object is cut by irradiating laser light onto both surfaces of the machining target object, and a storage process in which the machined machining target object is directly stored from the machining table to a storage member.

Since the machining table is inverted front to back and cutting is performed by irradiating laser light onto both sides of the machining target object, there is no need to receive the machining target object when it is inverted front to back, allowing the machining time to be shortened and productivity to be improved. In addition, thanks to machining from both surfaces, the machining depth from one surface can be reduced, allowing reduction of the required kerf width. As a result, it is possible to reduce the number of laser scanning lines, improving productivity. In addition, the pitch between machining target object packages can be reduced, and a layout can thereby be made with additional packages, increasing the number of packages per frame and improving productivity. In addition, thanks to machining from both surfaces, a taper shape caused by the laser machining can be reduced, improving quality.

### First Embodiment of the Present Invention

A first embodiment of the machining apparatus according to the present invention is described below with reference to the drawings. Regarding the figures shown below, they are schematically depicted with omissions or exaggerations for the sake of clarity. Identical components are marked with the same symbols, and descriptions are omitted where appropriate.

### Overall Configuration of the Machining Apparatus

The machining apparatus 100 in the present embodiment is a cutting apparatus that, by cutting a sealed substrate W which is the object to be cut, makes individual products P, which are a plurality of cut products.

The sealed substrate W is one wherein electronic elements such as semiconductor chips, resistor elements, and capacitor elements are fixed to a support body, which is resin molded so that at least the electronic elements are resin-sealed. As the support body, substrates such as lead frames or printed circuit boards can be used; in addition to these, substrates made of semiconductors (including silicon wafers and other semiconductor wafers), metal, ceramics, glass, resin, etc., can be used. Also, the substrate which makes up the sealed substrate W may or may not have wiring.

One surface of the sealed substrate W and product P in the present embodiment is a mounting surface on which mounting will be performed later. In the description of the present embodiment, the surface on which mounting will be performed later is referred to as the "mounting surface" and the surface opposite to that is referred to as the "marked surface."

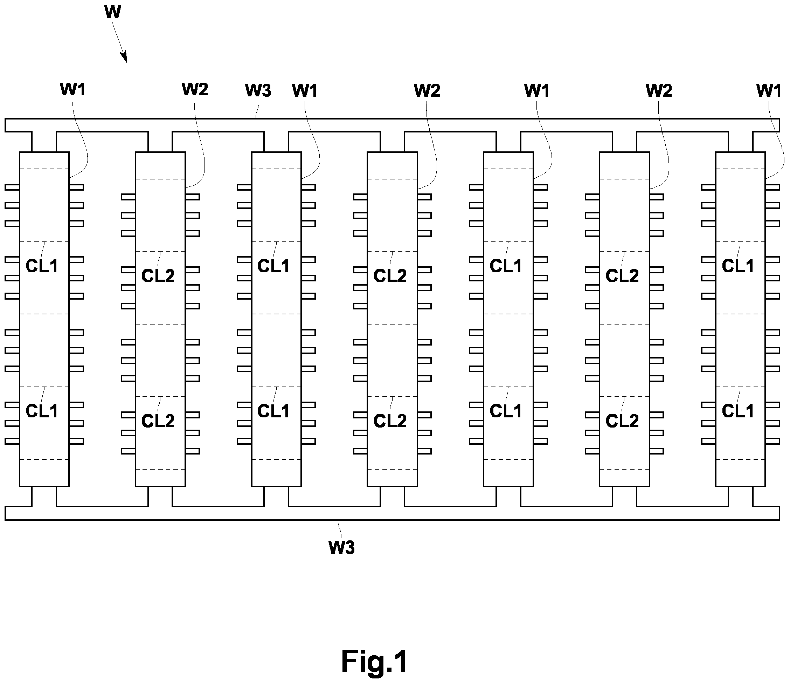

As shown in FIG 1, the sealed substrates W are such that a plurality of partition element elements W1, W2 are connected by a connecting portion W3, and the cutting lines CL1 and CL2 on the partition elements W1, W2 adjacent to each other are set on different straight lines. Each of the partition elements W1, W2 is one wherein a plurality of packages, in which electronic elements are sealed by resin molding, are arranged in a row. In addition, there is a lead corresponding to each package (electronic element). The plurality of partition elements W1, W2 are connected at both end portions thereof by connecting portions W3. Specifically, the partition elements W1 in odd-numbered columns and the partition elements W2 in even-numbered columns are configured such that their leads are alternated. As a result, the cutting lines CL1 of the partition elements W1 in odd-numbered columns are located along the same line, and the cutting lines CL2 of the partition elements W2 in even-numbered columns are located along the same line. Also, the cutting lines CL1 of the partition elements W1 in odd-numbered columns and the cutting lines CL2 of the partition elements W2 in even-numbered columns are located along different lines from each other. The cutting lines CL1 and CL2 shown in FIG 1 are imaginary lines that are scheduled to be cut, and are not shown on the actual sealed substrate W.

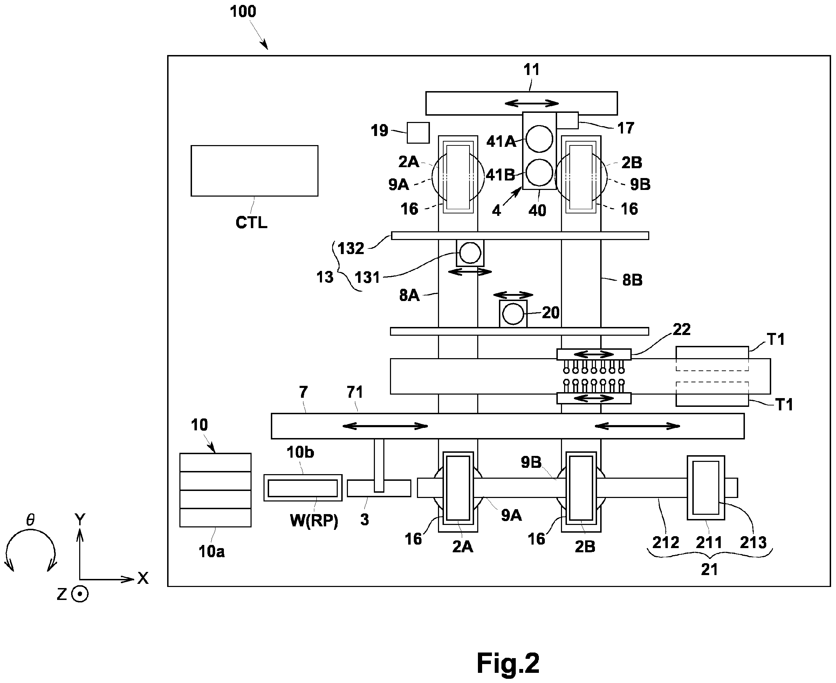

Specifically, as shown in FIG 2, the cutting apparatus 100 includes two cutting tables 2A, 2B that hold the sealed substrates W, a first holding mechanism 3 that holds the sealed substrates W for conveying the sealed substrates W to the cutting tables 2A, 2B, a cutting mechanism 4 that cuts the sealed substrates W held by the cutting tables 2A, 2B, and a conveying-use moving mechanism 7 that moves the first holding mechanism 3. The first holding mechanism 3 and conveying-use moving mechanism 7 constitute a conveying mechanism (loader) that conveys the sealed substrates W.

In the description below, the directions orthogonal to each other in the plane (horizontal plane) along the front surfaces of the cutting tables 2A, 2B are the X and Y directions, respectively, and the vertical direction orthogonal to the X and Y directions is the Z direction. Specifically, the left and right directions in FIG 2 are the X direction (first direction) while the up and down directions are the Y direction (second direction).

### Cutting Tables 2A, 2B

The two cutting tables 2A, 2B hold the sealed substrates W by suction, and are moveable in at least the Y direction. The cutting table 2A is movable in the Y direction by a cutting-use moving mechanism 8A, and rotatable in the θ direction by a rotation mechanism 9a. The cutting table 2B is movable in the Y direction by a cutting-use moving mechanism 8B, and rotatable in the θ direction by a rotation mechanism 9B. The specific configuration of the cutting tables 2A, 2B is described below.

### First Holding Mechanism 3

As shown in FIG 2, the first holding mechanism 3 holds the sealed substrates W to convey the sealed substrates from a substrate supply mechanism 10 to the cutting tables 2A, 2B. The first holding mechanism 3 has a plurality of suction units (not shown) for holding the sealed substrates W by suction. The first holding mechanism 3 conveys the sealed substrates W from the substrate supply mechanism 10 to the cutting tables 2A, 2B by being moved to a desired position by the conveying-use moving mechanism 7 or the like, described below.

As shown in FIG 2, the substrate supply mechanism 10 has a substrate storage unit 10a in which a plurality of sealed substrates W are externally stored, and a substrate supply unit 10b that moves sealed substrates W which are stored in the substrate storage unit 10a to a holding position RP where they are held by suction by the first holding mechanism 3.

### Cutting Mechanism 4

As shown in FIG 2, the cutting mechanism 4 cuts the sealed substrates W by irradiating laser light onto the sealed substrates W suctioned to the cutting tables 2A, 2B, and has two laser light irradiating units 41A, 41B.

The two laser light irradiating units 41A, 41B are arranged along the Y direction, and each is configured independently and is capable of respectively irradiating laser light. Each laser light irradiating unit 41A, 41B has a laser oscillator; a laser light scanning unit, e.g. a galvano scanner, that linearly scans the laser from said laser oscillator; and a condenser lens that focuses the laser light. In each of the laser light irradiating units 41A, 41B, the laser light is concentrated by the condenser lens onto the sealed substrates W held by suction to the cutting tables 2A, 2B, and is linearly scanned along the sealed substrates W held by suction to the cutting tables 2A, 2B by the laser light scanning unit.

In the present embodiment, the two laser light irradiating units 41A, 41B are provided to a single machining head 40, and said machining head 40 can be moved between the two cutting tables 2A, 2B along the X direction by a machining head moving mechanism 11. The machining head moving mechanism 11 may also move the machining head 40 along the Y direction and the Z direction. Otherwise, the two laser light irradiating units 41A, 41B can be configured to be movable in at least in the X direction or the Y direction relative to the machining head 40. The two laser light irradiating units 41A, 41B may be configured to each be independent and moveable between the two cutting tables 2A, 2B.

The cutting on the cutting table 2A is such that the sealed substrate W is cut into individual pieces by moving the cutting table 2A and the two laser light irradiating units 41A, 41B relative to each other and scanning the laser light. The cutting on the cutting table 2B is such that the sealed substrate W is cut into individual pieces by moving the cutting table 2B and the two laser light irradiating units 41A, 41B relative to each other and scanning the laser light. Moreover, the cutting processing on cutting table 2A and the cutting processing on cutting table 2B can be performed alternately.

### Conveying-use Moving Mechanism 7

As shown in FIG 2, the conveying-use moving mechanism 7 moves the first holding mechanism 3 between at least the substrate supply mechanism 10 and the cutting table 2A, 2B.

As shown in FIG 2, the conveying-use moving mechanism 7 extends in a straight line along the direction of arrangement of the two cutting tables 2A, 2B (the X direction) and has a transfer shaft 71 for moving the first holding mechanism 3. The transfer shaft 71 is provided so as to have a range such that the first holding mechanism 3 can move above the substrate supply unit 10b of the substrate supply mechanism 10 (see FIG 2).

Furthermore, the conveying-use moving mechanism 7 is configured such that the first holding mechanism 3 is movable in the X direction and the Z direction, respectively, relative to the transfer shaft 71. For example, the moving mechanism, in each direction, may be a rack-and-pinion mechanism, may be a ball screw mechanism, may be an air cylinder, or may be a linear motor.

### The Specific Configuration of the Cutting Tables 2A, 2B

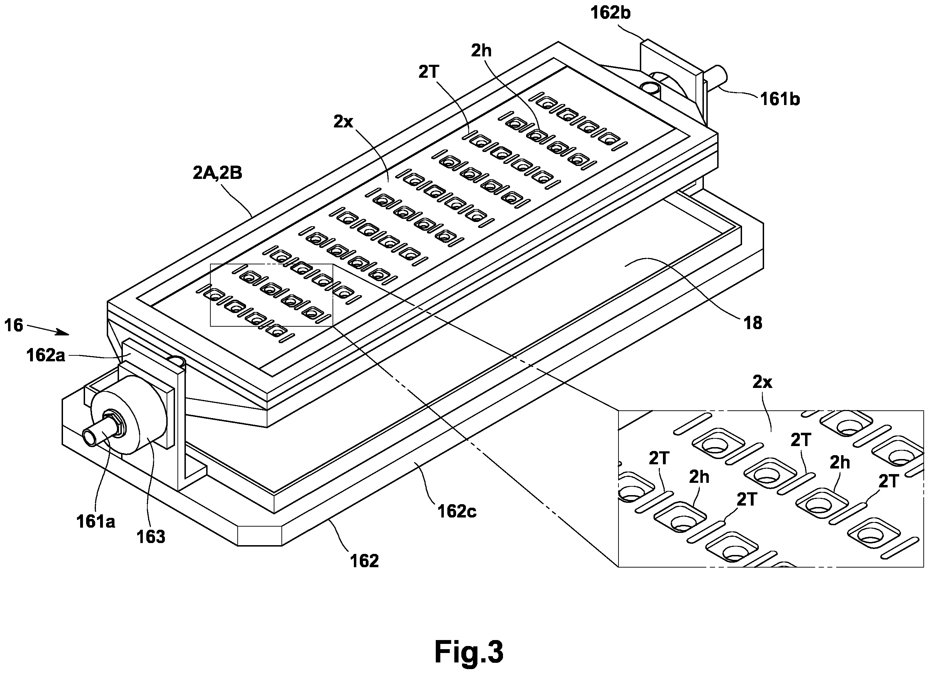

Next. the specific configuration of the cutting tables 2A, 2B is explained with reference to FIGs 3 - 8.

### The Suction Function of Cutting Tables 2A, 2B

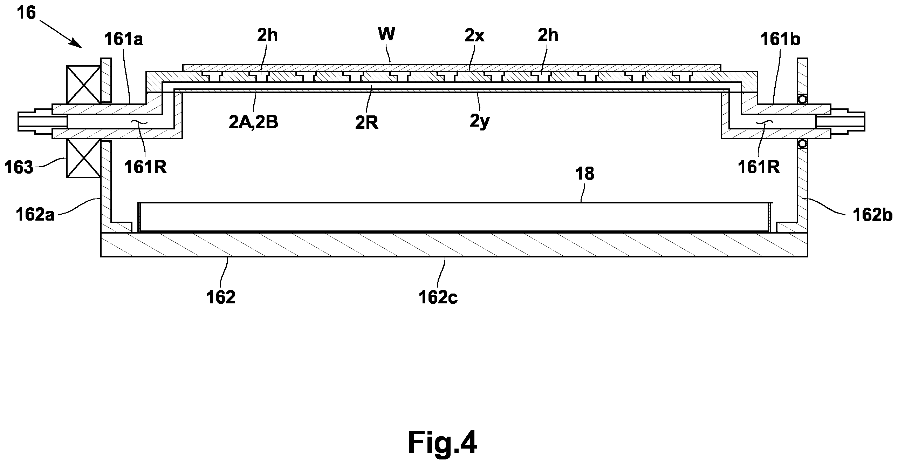

As shown in FIGs 3 and 4, each of the cutting tables 2A, 2B is provided with a plurality of suction holes 2h on a one surface 2x that can suction a sealed substrate W. The plurality of suction holes 2h are connected to a suction flow path 2R formed within the cutting tables 2A, 2B. Moreover, the suction flow path 2R is connected to a vacuum pump not shown in the figures.

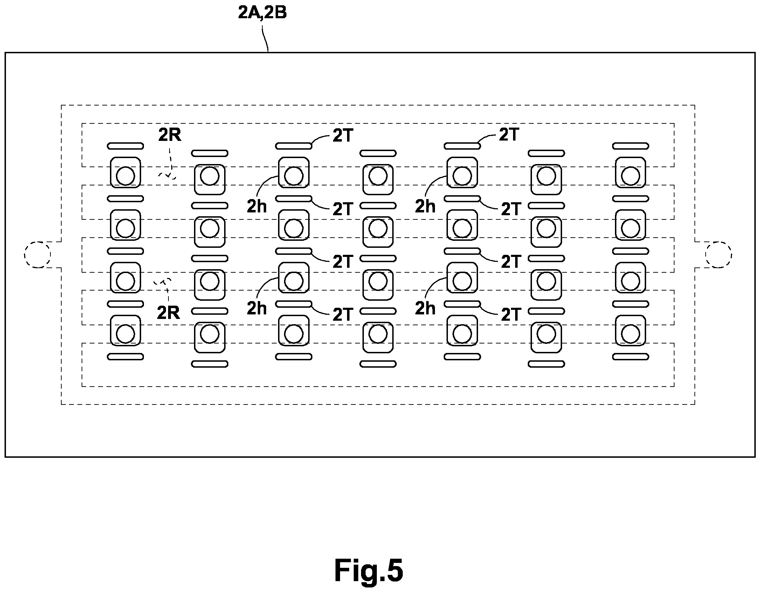

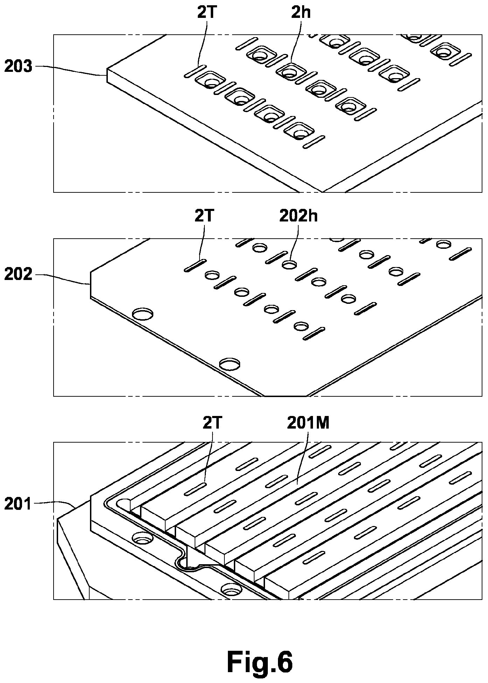

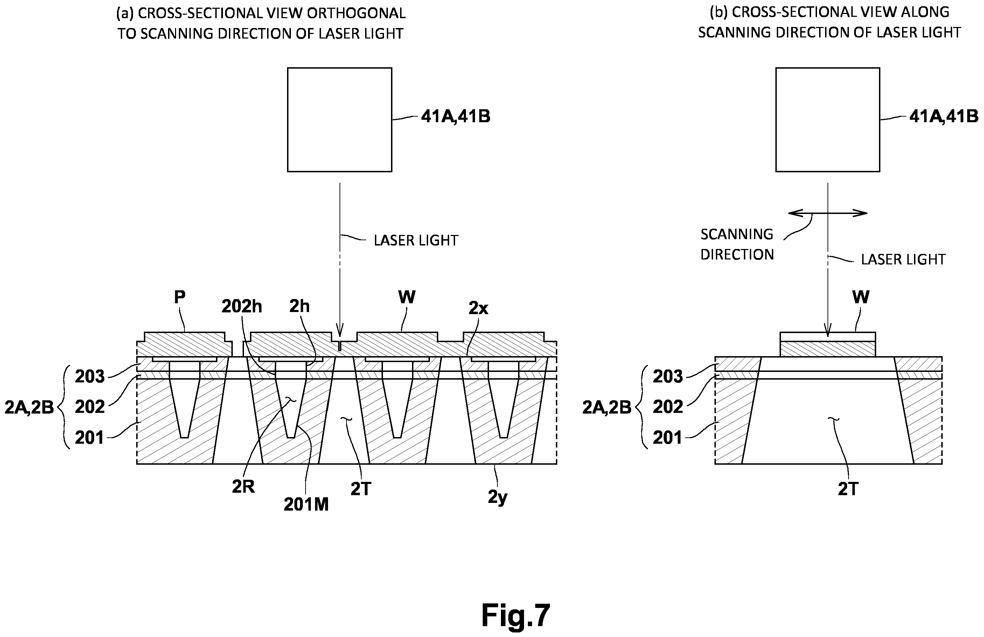

Specifically, as shown in FIG 5, the cutting tables 2A, 2B have a roughly rectangular shape in plan view and, as shown in FIGs 6 and 7, consist of a base plate 201 having a groove 201M on its upper surface that forms the suction flow path 2R, a cover plate 202 provided on the upper surface of the base plate 201 to cover up the groove 201M and being formed with suction through-holes 202h that communicates with the groove 201M, and a suction rubber 203 made of resin, which is fastened to the front surface of the cover plate 202 and has suction holes 2h in communication with the suction through-holes 202h. The suction rubber 203 allows the sealed substrate W to be firmly fixed in place without damage or leakage when the sealed substrate W is suctioned. The front surface of the suction rubber 203 is the one surface 2x of the cutting tables 2A, 2B, and the back surface of the base plate 201 is the another surface 2y of the cutting tables 2A, 2B.

### The Inversion Function of Cutting Tables 2A, 2B

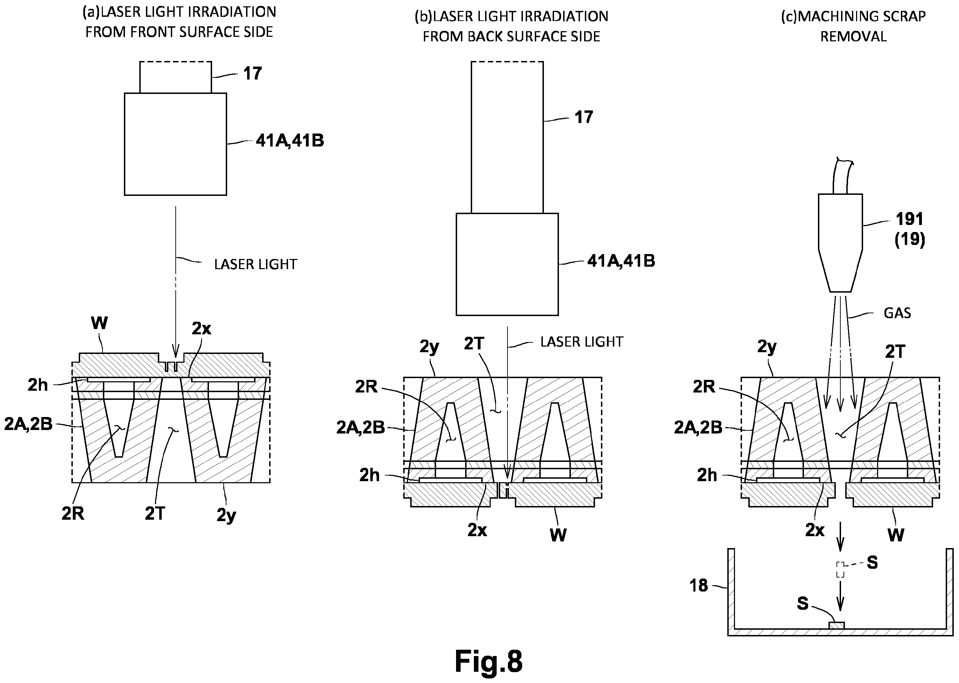

As shown in FIG 3 and FIG 4, each of the cutting tables 2A, 2B can be inverted front to back by a table inversion mechanism 16. The cutting tables 2A, 2B are thus configured so they can be switched between a state in which the one surface 2x faces upward (towards the laser light irradiating units 41A, 41B) (see Figure 8(a)) and a state in which the another surface 2y faces upward (towards the laser light irradiating units 41A, 41B) (see Figure 8(b)).

As shown in FIG 3 and FIG 4, the table inversion mechanism 16 rotatably supports both mutually opposing side portions of the cutting tables 2A, 2B; in this case, it rotatable supports both end portions of the cutting tables 2A, 2B in the longitudinal direction. This allows the cutting tables 2A, 2B to pass through a smaller area when inverting the cutting tables 2A, 2B front to back. The cutting tables 2A, 2B are configured to be detachable from the table inversion mechanism 16, and can be changed to dedicated cutting tables 2A, 2B according to the form of the sealed substrate W.

Specifically, the table inversion mechanism 16 has two rotary shaft units 161a and 161b provided at both end portions in the longitudinal direction of the cutting tables 2A, 2B, a base member 162 that supports said rotary shaft units 161a and 161b to be rotatable via a shaft bearing portion which is a rolling bearing or the like, and a rotary drive unit 163 such as a motor or rotary cylinder, provided to one of the rotary shaft units 161 that inverts the cutting tables 2A, 2B front to back. Moreover, the base member 162 has two support walls 162a and 162b that rotatably support the two rotary shaft units 161, and a bottom wall 162c provided to the two support walls 162a and 162b. In the present embodiment, one of the rotary shaft units 161a is configured to be rotatably supported by the support wall 162a via the rotary drive unit 163.

The two rotary shaft units 161a, 161b are provided in the center portion of each of both end portions of the cutting tables 2A, 2B in the longitudinal direction in plan view. The two rotary shaft units 161a and 161b have their centers of rotation along the same line and extend horizontally. The two rotary shaft units 161a and 161b extend in the longitudinal direction of the cutting tables 2A, 2B. In addition, as shown in FIG 4, at least one of the two rotary shaft units 161a and 161b has an internal flow path 161R that is connected to the suction flow path 2R formed within the cutting tables 2A, 2B, and this internal flow path 161R is connected to a vacuum pump not shown.

Moreover, the center of rotation of the rotary shaft units 161a and 161b may be configured to align with the center of the cutting tables 2A, 2B or the center of the sealed substrate W held by suction to the cutting tables 2A, 2B. Thanks to this configuration, the change in the height position of the sealed substrate W before and after being inverted front to back can be reduced, and adjustments of the relative position with respect to the laser light irradiating units 41A, 41B can be made unnecessary or simple.

### Through Openings 2T in Cutting Tables 2A, 2B

In the present embodiment, as shown in FIGs 3 to 8, the cutting tables 2A, 2B have a plurality of through openings 2T through which the laser light can pass from the one surface 2x in which the suction holes 2H are provided, to the another surface 2y, which is the surface on the back side of said one surface 2x. The sealed substrate W is cut at the through openings 2T by laser light from the laser light irradiating units 41A, 41B of the cutting mechanism 4.

As shown in FIG 5, in the plan view of the cutting tables 2A, 2B-that is, as viewed from the one surface 2x side of the cutting tables 2A, 2B-the plurality of through openings 2T are formed in a position which does not overlap with the plurality of suction holes 2h and the suction flow path 2R (specifically, the groove 201M in the base plate 201) in communication with said plurality of suction holes 2h.

The plurality of through openings 2T are formed in positions corresponding to the cutting lines CL1 and CL2 of the sealed substrate W (see FIG 1), and are formed to include the cutting lines CL1 and CL2 in the plan view of the cutting tables 2A, 2B. Specifically, each of the through openings 2T is longer than the length of each cutting line CL1 and CL2 in the cutting direction (machining direction) and has a width greater than the kerf width which is removed between packages. The through openings 2T have an opening size so as not to be hit by the laser light irradiated from the laser light irradiating units 41A, 41B.

In the present embodiment, as shown in FIG 2, the sealed substrate W is such that the cutting lines CL1 of the partition elements W1 in odd-numbered columns and the cutting lines CL2 of the partition elements W2 in even-numbered columns are located along straight lines which are different from each other; therefore, the plurality of through openings 2T formed in the cutting tables 2A, 2B are similar in that the through openings 2T corresponding to the cutting lines CL1 of the partition elements W1 in odd-numbered columns and the through openings 2T corresponding to the cutting lines CL2 of the partition elements W2 in even-numbered columns are located on straight lines which are different from each other (see FIG 5).

As shown in FIG 7 and FIG 8, the through openings 2T have a shape that gradually widens as it opens from the one surface 2x, where the suction holes 2h are provided, to the another surface 2y. Specifically, the through openings 2T have a shape that widens as it opens from the one surface 2x to the another surface 2y in the cross section perpendicular to the scanning direction of the laser light. Moreover, the through openings 2T can be of any shape so as not to be hit by the laser light, and may be of an equal cross-sectional shape, or may be of a shape that expands in steps as it widens to open from the one surface 2x to the another surface 2y.

Moreover, in the present embodiment, as shown in FIG 8, since the height position of the sealed substrate W changes when the cutting tables 2A, 2B are inverted front to back, a position change mechanism 17 is also included that changes the relative positions of the cutting tables 2A, 2B and the laser light irradiating units 41A, 41B before and after the cutting tables 2A, 2B are inverted front to back. The position change mechanism 17 changes the relative positions of the cutting tables 2A, 2B and the laser light irradiating units 41A, 41B to adjust the position of the focal point of the laser light onto the sealed substrate W.

The position change mechanism 17 can be provided to a machining head moving mechanism 11 that moves the machining head 40 (see FIG 2), and can change the height position of the machining head 40 (laser light irradiating units 41A, 41B) before and after the cutting tables 2A, 2B are inverted front to back. The position change mechanism 17 may also be constituted by the machining head moving mechanism 11. Moreover, the height positions of the cutting tables 2A, 2B may be changed so that the height positions before and after the inverting from front to back are the same.

### Machining Scraps Storage Unit 18

As shown in FIGs 3, 4, and 8(c), the cutting apparatus 100 of the present embodiment is further provided with a machining scraps storage unit 18 that stores machining scraps S, such as edge material generated by cutting the sealed substrate W. The machining scraps storage unit 18 is provided below the cutting tables 2A, 2B. Specifically, the machining scraps storage unit 18 is provided between the two support walls 162a and 162b to the base member 162 that supports the cutting tables 2A, 2B. Moreover, the machining scraps storage unit 18 is configured to be detachable from the base member 162, and once it has been removed from the base member 162 the machining scraps S can be disposed of externally to the cutting apparatus 100.

Moreover, if the distance between the machining head 40 and the machining scraps storage unit 18 is short, because the energy density of the laser light passing through the through opening 2T is high, it may scatter at the back surface of the machining scraps storage unit 18. To minimize this, an absorbent surface treatment may be applied to the back surface of the machining scraps storage unit 18, or an absorbent material may be provided on the back surface of the machining scraps storage unit 18.

### Machining Scrap Removal Mechanism 19

As shown in FIG 8(c), the cutting apparatus 100 of the present embodiment further includes a machining scrap removal mechanism 19 that removes machining scraps S such as edge material remaining on the sealed substrate W which has been cut by the laser light.

The machining scrap removal mechanism 19 has a gas jet unit 191 that blows compressed air or another gas towards the sealed substrate W, and machining scraps S are removed by the jet of gas emitted by said gas jet unit 191. The gas jet unit 191 is provided above the cutting tables 2A, 2B, and is configured to remove the machining scraps S by blowing gas from above towards the cutting tables 2A, 2B, which have been inverted front to back. With this configuration, the jet of gas emitted by the gas jet unit 191 passes through a through opening 2T and is blown onto a remaining machining scrap S. Here, the jet of gas is narrowed at the through opening 2T, which allows the gas to increase in velocity and be focused onto the machining scrap S it hits. The removed machining scraps S are stored in the machining scraps storage unit 18 provided below the cutting tables 2A, 2B. A configuration in which machining scraps S are removed by blowing gas from above onto the cutting tables 2A, 2B which have not been inverted front to back is also possible.

In addition to the above configuration in which gas is blown onto the remaining machining scraps S, it is also possible that the machining scrap removal mechanism 19 is instead configured to physically contact machining scraps S and push them off. In this case, the machining scrap removal mechanism 19 has a push-off member, such as a pin, that pushes off the machining scraps S, and by moving the push-off member up and down with respect to the cutting tables 2A, 2B, a machining scrap S is pushed off toward the machining scraps storage unit 18.

### Inspection Unit 13

As shown in FIG 2, the present embodiment has an inspection unit 13 that inspects by imaging a plurality of products P cut by the cutting mechanism 4 from the front surface side.

The inspection unit 13 images the front surface of a plurality of products P from above the cutting tables 2A, 2B. When inspecting the products P with the inspection unit 13, the cutting tables 2A, 2B are not in a state of being inverted front to back.

Specifically, the inspection unit 13 has an inspection camera 131 with an optical system for imaging the front surface of the plurality of products P held by suction to the cutting tables 2A, 2B. The inspection camera 131 is provided so as to be movable in the X direction between the transfer shaft 71 and the cutting mechanism 4 by a camera moving mechanism 132. It is preferable that the inspection camera 131 has a fast shutter speed, and that the exposure time is short.

The camera moving mechanism 132 of the present embodiment allows movement of the inspection camera 131 between the two cutting tables 2A, 2B. When a plurality of products P held by suction to one of the cutting tables 2A is imaged, the camera moving mechanism 132 moves the inspection camera 131 above the cutting table 2A. Here, the cutting table 2A is moved in the Y direction by the cutting-use moving mechanism 8A, to a state of being in a predetermined inspection position. When a plurality of products P held by suction to the other of the cutting tables 2B is imaged, the camera moving mechanism 132 moves the inspection camera 131 to above the cutting table 2B. Here, the cutting table 2B is moved in the Y direction by the cutting-use moving mechanism 8B, to a state of being in a predetermined inspection position.

Then, the camera moving mechanism 132 moves the inspection camera 131 in the X direction above the cutting table 2A, 2B, and the front surfaces (mounting surface) of the products P suctioned to the cutting table 2A, 2B are imaged.

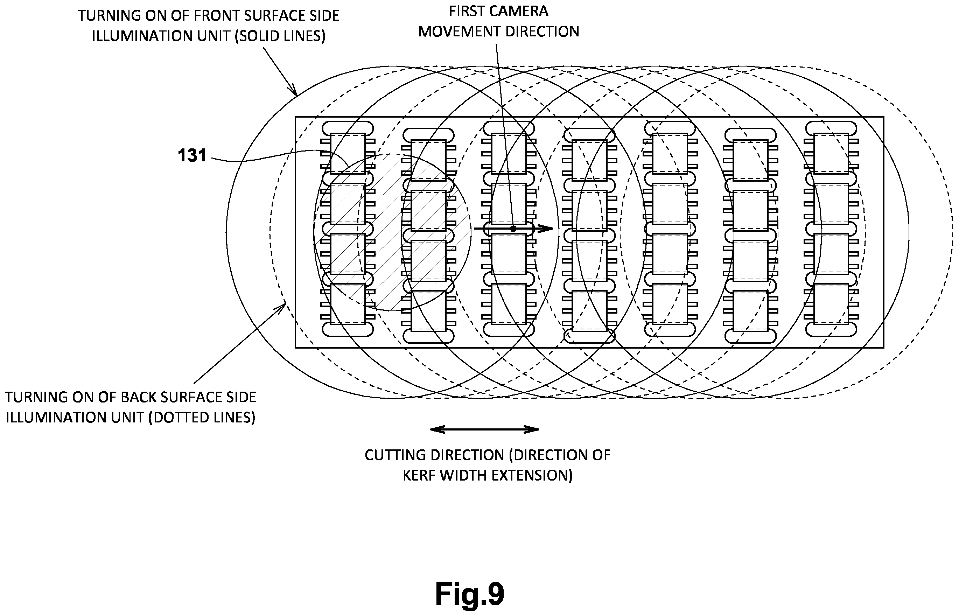

Specifically, as shown in FIG 9, the camera moving mechanism 132 moves the inspection camera 131 relative to the cutting table 2A, 2B along the cutting direction of the cut performed by the cutting mechanism 4 (the direction in which the kerf extends). At that time, the cutting table 2A, 2B is in a state of having been rotated by the rotation mechanism 9A, 9B so that the cutting direction of the cut performed by the cutting mechanism 4 (the direction in which the kerf extends) is parallel to the X direction.

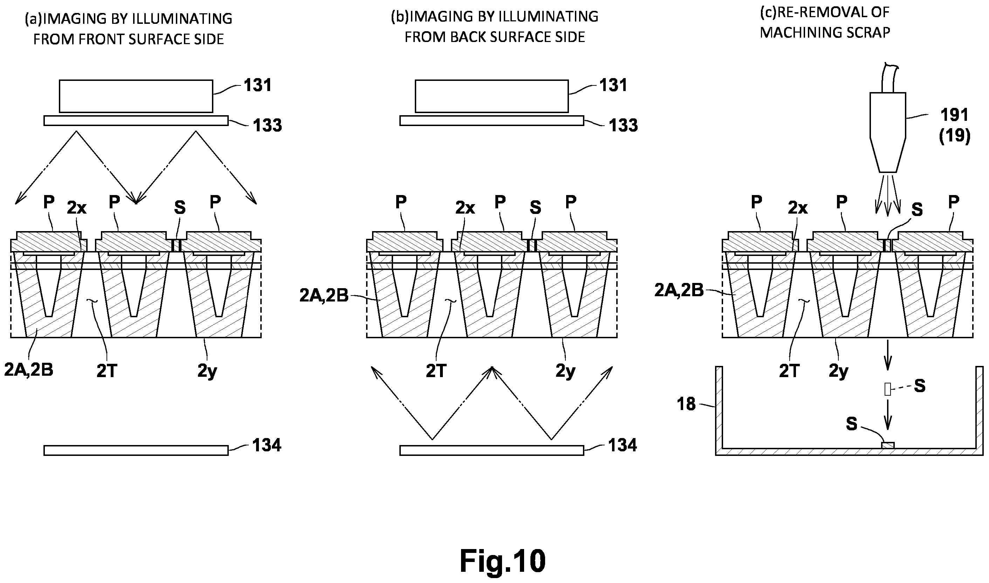

As seen in FIG 10, the present embodiment further includes a front surface side illumination unit 133 provided on the same side as the inspection camera 131 with respect to the cutting tables 2A, 2B that illuminate the front surface side of the plurality of products P, and a back surface side illumination unit 134 provided on the opposite side of the cutting tables 2A, 2B to that of the inspection camera 131, which generates transmitted light that passes through the through openings 2T and illuminates the back surface side of the plurality of products P through the through openings 2T

The front surface side illumination unit 133 and the back surface side illumination unit 134, respectively, are strobe-emitting lighting devices; for example, in this case they are configured using xenon lamps. The front surface side illumination unit 133 may be integrated with the inspection camera 131, or it may be provided separately. The back surface side illumination unit 134 is provided so as to be movable to below the cutting tables 2A, 2B which are in the predetermined inspection position.

As shown in FIG 9, while moving the inspection camera 131 relative to the cutting table 2A, 2B, the front surface side illumination unit 133 and the back surface side illumination unit 134 are alternately turned on, and each time the front surface side illumination unit 133 and the back surface side illumination unit 134 are respectively turned on, the inspection camera 131 images the plurality of products P held by suction to the cutting table 2A, 2B. The inspection camera 131 thereby continuously captures images of the plurality of products P illuminated from the front surface side, and images of the plurality of products P illuminated from the back surface side.

Each image obtained by the inspection camera 131 undergoes image processing by an image processing unit composed by a control unit CTL, and measurement and inspection of the external appearance of the products P, such as the kerf width between them, is carried out, and it is determined if the products P are of good quality or are defective products, etc. Here, images in which the products P are illuminated from the front surface side are used, for example, for inspection of the external appearance of the front surfaces (mounting surfaces) of the products P, or for measurement of the dimensions of the front surface side edge portion of the kerf formed between the products P, etc. On the other hand, images in which the products P are illuminated from the back surface side are used, for example, for inspection for the presence or absence of machining scraps such as edge material remaining between the products P, or for measurement of the minimum width of the kerf formed between the products P.

### Defective Product Removal Mechanism 22

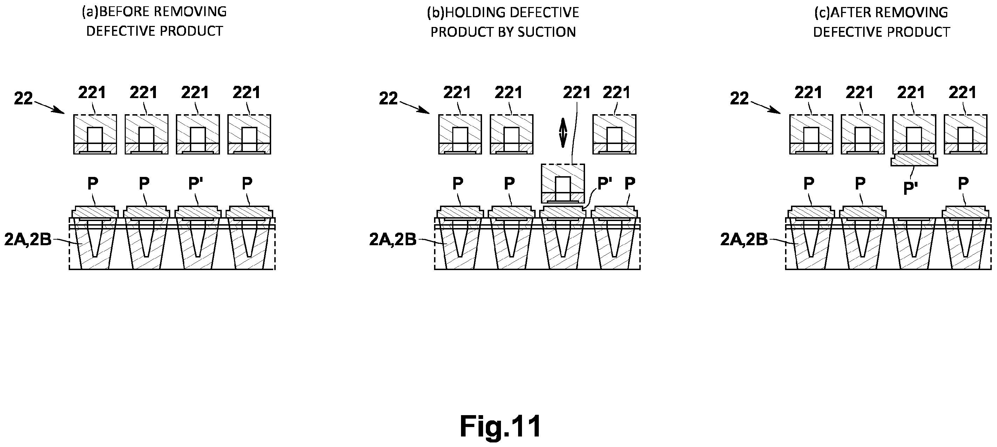

As shown in FIG 2 and FIG 11, the cutting apparatus 100 of the present embodiment further includes a defective product removal mechanism 22 which removes products P judged to be defective (hereafter, P') by the inspection using the inspection camera 131 from the cutting tables 2A, 2B.

Specifically, before the plurality of products P are stored in a storage box 211, the defective product removal mechanism 22 stores defective products P' in a defective product tray T1. The defective product removal mechanism 22 is moveable between the cutting tables 2A, 2B and the defective product tray T1, and selectively holds by suction and lifts defective products P' from among the plurality of products P on the cutting tables 2A, 2B and conveys them to the defective product tray T1. Specifically, as seen in FIG 11, the defective product removal mechanism 22 has a plurality of suction units 221 which individually hold each product P by suction and can be individually raised and lowered. When a defective product P' is removed, the suction unit 221 corresponding to the defective product P' is lowered to pick up the defective product P' by suction and then subsequently raised. Then the defective product P' picked up by suction by the defective product removal mechanism 15 is conveyed to defective product tray T1 and disposed of or reworked. Moreover, the number of defective products P' is usually small, so the number of conveyances is small and does not become a bottleneck for improve the productivity of producing products P.

### Storage Mechanism 21 of Products P

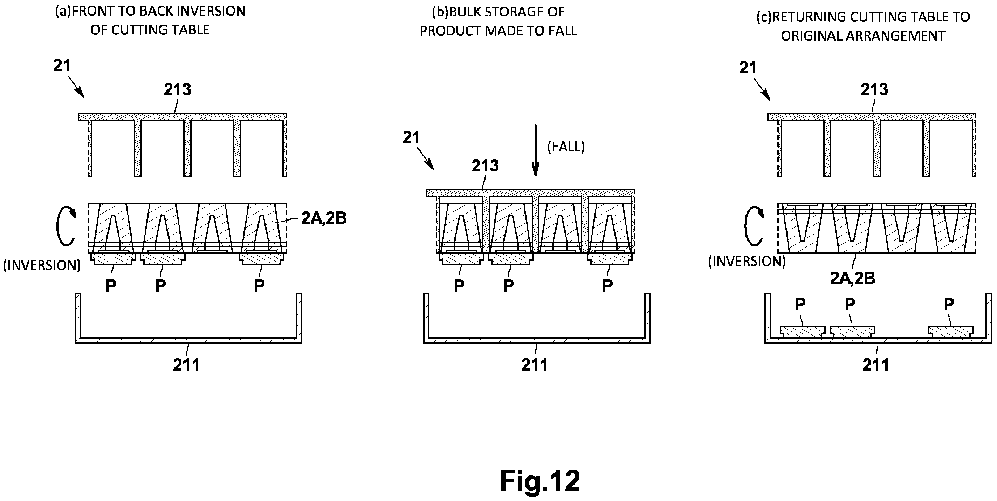

As shown in FIG 2 and FIG 12, the cutting apparatus 100 of the present embodiment includes a storage mechanism 21 that directly stores a plurality of products P from the cutting tables 2A, 2B into the storage box 211, which is a storage member.

Specifically, the storage mechanism 21 is one that stores a plurality of products P in a discrete state (this is also referred to as `bulk storage') in the storage box 211, and includes the storage box 211 which stores the plurality of products P that have fallen from the cutting tables 2A, 2B that have been inverted front to back.

The storage box 211 is provided so as to be movable between a catching position, which is a position below the cutting tables 2A, 2B that have been inverted front to back, and an evacuated position, which is away from below the cutting tables 2A, 2B that have been inverted front to back. Here, the storage box 211 moves between the catching position and the evacuated position by moving along the X direction via a box moving mechanism 212. Moreover, in the present embodiment, the storage box 211 in the catching position is located between the cutting tables 2A, 2B and the machining scraps storage unit 18.

Here, when the cutting table 2A, 2B is inverted front to back and the plurality of products P are made to fall into the storage box 211 from said cutting table 2A, 2B, there are cases in which the products P stick firmly to the cutting table 2A, 2B and the products P cannot be reliably stored in the storage box 211. For this reason, as shown in FIG 12, a pushing member 213 such as a pin may be used to push the back surface of the product P from the through opening 2T of the cutting table 2A, 2B to separate it from the cutting table 2A, 2B. The pushing member 213 is one that pushes the plurality of products P downward through the through openings 2T from above with respect to the cutting table 2A, 2B that is inverted front to back. Moreover, a configuration is also possible wherein a pushing member 213 is not provided, the plurality of products P instead being made to fall by, after releasing the suction hold of the cutting table 2A, 2B, blowing gas from the suction holes 2h of the cutting table 2A, 2B. The plurality of products P may also be made to drop by combining the push by the pushing member 213 and the emitting of a jet of gas from the suction holes 2h.

### Example of Operation of the Cutting Apparatus 100

Next, an example of the operation of the cutting apparatus 100 wil be described. Moreover, in the present embodiment, all operation and control of the cutting apparatus 100, such as conveyance of the sealed substrates W, the laser cutting of the sealed substrates W, the removal of machining scraps S, the inspection of the products P, the removal of defective products P', and bulk storage of products P, are performed by the control unit CTL (see FIG 2).

The substrate supply unit 10b of the substrate supply mechanism 10 moves the sealed substrates W stored in the substrate storage unit 10a toward a holding position RP where they are held by the first holding mechanism 3.

Next, the conveying-use moving mechanism 7 moves the first holding mechanism 3 to the holding position RP, and the first holding mechanism 3 holds the sealed substrates W by suction. The conveying-use moving mechanism 7 then moves the first holding mechanism 3 holding the sealed substrates W to the cutting tables 2A, 2B, and the first holding mechanism 3 releases the suction and places the sealed substrates W on the cutting tables 2A, 2B. Then, the cutting tables 2A, 2B hold the sealed substrate W by suction.

### Cutting Process

In this state, the cutting-use moving mechanisms 8A, 8B move the cutting tables 2A, 2B to a predetermined cutting position (an inner side of transfer shaft 71). At the cutting position, the sealed substrates W are cut into individual pieces by the cutting tables 2A, 2B and the two laser light irradiating units 41A, 41B being moved relative to each other in the X and Y directions by the cutting-use moving mechanisms 8A, 8B and the machining head moving mechanism 11. Moreover, if necessary, the cutting tables 2A, 2B are rotated by the rotation mechanisms 9A, 9B.

Next, the cutting method will be described in specifics.

First, after the sealed substrates W are suctioned and held to the cutting tables 2A, 2B, alignment (position adjustment) of the sealed substrates W and the laser light irradiating units 41A, 41B is carried out. Here, alignment marks on the sealed substrates W are imaged by an alignment camera 20, and the captured data is used to carry out the alignment.

Then, without inverting the cutting tables 2A, 2B with the table inversion mechanism 16, as shown in FIG 8(a), laser light is irradiated from the laser light irradiating units 41A, 41B onto the front surface of the sealed substrates W to cut a portion thereof and machine a groove (half cut). In FIG 8(a), an example is shown wherein two grooves have been machined between packages to match the kerf width of a case in which a blade cut is done.

As shown in FIG 8(b), after the groove machining described above, the cutting tables 2A, 2B are inverted front to back by the table inversion mechanism 16. After inversion, alignment (position adjustment) is not carried out, and data is used which was obtained by inverting the imaging data from before the inversion, using the rotation axes of the rotary shaft units 161a and 161b as a standard. Further, when the height position of the sealed substrate W is changed due to the inversion of the cutting tables 2A, 2B, the relative positions of the cutting tables 2A, 2B and the laser light irradiating units 41A, 41B are changed by the position change mechanism 17, and the position of the focal point of the laser light is adjusted onto the sealed substrate W. Then, on the back surface of the sealed substrate W, laser light is irradiated from the laser light irradiating units 41A, 41B through the through openings 2T, cutting the portions into which a groove had been machined with a half cut, such that they are cut through completely (a full cut). The machining scraps S, such as edge material, generated by this full cut fall down and are stored in the machining scraps storage unit 18.

Moreover, regarding the half cut and full cut mentioned above, when the laser light irradiating units 41A, 41B are moved to different cutting lines CL1 and CL2, the irradiation of laser light by the laser light irradiating units 41A, 41B is stopped. The inversion via the table inversion mechanism 16 may be repeated a plurality of times in accordance with the type of sealed substrate W, the cutting process, etc.

As shown in FIG 8(c), after the cutting described above, the gas jet unit 191 of the machining scrap removal mechanism 19 is moved above the cutting tables 2A, 2B, and machining scraps are removed by blowing gas from above onto the cutting tables 2A, 2B which have been inverted front to back. The machining scraps S removed by the machining scrap removal mechanism 19 fall into the machining scraps storage unit 18 and are stored therein. Moreover, before moving the machining scrap removal mechanism 19 to above the cutting tables 2A, 2B, the laser light irradiating units 41A, 41B are moved away by the machining head moving mechanism 11 to a position in which they will not get in the way.

### Inspection Process

After removal of the machining scraps S, the cutting-use moving mechanisms 8A, 8B move the cutting tables 2A, 2B to a predetermined inspection position. Here, the cutting tables 2A, 2B are in a state of not having been inverted front to back by the table inversion mechanism 16. Then, the inspection camera 131 of the inspection unit 13 images the plurality of products P suctioned by the cutting tables 2A, 2B by being moved in the X direction by the camera moving mechanism 132. Here, as shown in FIG 9 and FIG 10, the camera moving mechanism 132 alternately turns on the front surface side illumination unit 133 and the back surface side illumination unit 134 while moving the inspection camera in the X direction, and images the plurality of products P when each illumination unit 133 and 134 is turned on. Then, each image captured by the inspection camera 131 is sent to the image processing unit of the control unit CTL, and it is determined if the products are of good quality or are defective products, etc. If the inspection unit 13 detects a machining scrap S remaining between the products P, the gas jet unit 191 of the machining scrap removal mechanism 19 described above can conduct removal of the machining scraps S again (see FIG 10(c)).

### Defective Product Removal Process

After the removal of machining scraps S and front surface inspection of the products P, the cutting-use moving mechanisms 8A, 8B move the cutting tables 2A, 2B to a predetermined defective product removal position (the inner side of the transfer shaft 71). Then, as shown in FIG 11, based on the inspection result of the inspection unit 13, the defective product removal mechanism 22, via the suction unit 221, selectively holds by suction and picks up, from the cutting tables 2A, 2B which are in the defective product removal position, products P which have been determined to be defective products P' and conveys them to the defective product tray T1.

### Storage Process

After removal of defective products, the cutting-use moving mechanisms 8A, 8B move the cutting tables 2A, 2B to a predetermined storage position (just before the transfer shaft 71). Moreover, the storage position of the present embodiment is the same as the conveying position to which the sealed substrate W is conveyed by the first holding mechanism 3, but it may also be a different position.

Then, the box moving mechanism 212 moves the storage box 211 of the storage mechanism 14 to the catching position located below the cutting tables 2A, 2B. After that, as shown in FIG 12, the cutting tables 2A, 2B, which are in the storage position, are inverted front to back in a state in which the plurality of products P are held by suction. In this state, the suction hold of the cutting tables 2A, 2B is released, and the plurality of products P are pushed below through the through openings 2T by the pushing member 213. Due to this, the plurality of products P fall down from the cutting tables 2A, 2B, and are directly stored into the storage box 211. After that, the box moving mechanism 212 moves the storage box 211, in which the plurality of products P have been stored, to the evacuated position. In the evacuated position, the storage box 211 can be removed to an exterior of the cutting apparatus 100.

### Effect of the Present Embodiment

In the cutting apparatus 100 of the present embodiment, the plurality of products P are directly stored into the storage box 211 from the cutting tables 2A, 2B, and therefore there is no need to separately convey the plurality of products P from the cutting tables 2A, 2B to the storage box 211, simplifying the cutting apparatus 100 and improving productivity. The footprint of the cutting apparatus 100 can also be reduced thanks to being simplified.

Since the cutting tables 2A, 2B to which the sealed substrates W are held by suction are inverted front to back, it is possible to cut the sealed substrate W from both surfaces, shortening the cutting time and improving productivity.

Furthermore, if the amount of position shift which occurs when the cutting tables 2A, 2B are inverted front to back is measured once in advance, the position after inversion can be corrected via calculation, eliminating the need to perform alignment (position adjustment) again for each inversion. Therefore, alignment (position adjustment) of the laser light irradiating unit 41A, 41B with respect to the sealed substrate W only needs to be performed once after the sealed substrate W is held by suction, which also reduces the cutting time and improves productivity.

In addition, since a plurality of through openings 2T through which the laser light can pass are provided to the cutting table 2A, 2B, the laser light passes through the through openings 2T when the sealed substrate W in the portion corresponding to said through openings 2T is irradiated with laser light and cut, thereby preventing the cutting tables 2A, 2B from being hit. As a result, it is possible to suppress damage to the cutting tables 2A, 2B due to irradiation by laser light, as well as contaminants (impurities and foreign matter) adhering to the sealed substrate W as a consequence thereof, and it is also possible to reduce constraints on laser machining conditions meant to prevent damage to the cutting tables 2A, 2B. The ability to reduce constraints on laser machining conditions allows the use of higher pulse energy and average power, thereby reducing machining time and increasing productivity.

In addition, since the laser light passes through the through openings 2T, the laser light is prevented from reflecting off the cutting tables 2A, 2B and being irradiated onto the sealed substrate W, and damage to the sealed substrate W by the laser light reflected off the cutting tables 2A, 2B can be suppressed.

Since the through openings 2T widen as they open toward the another surface 2y, the laser light is emitted from the one surface 2x and, as for the laser light that passes through the sealed substrate W, the laser light does not hit the inner surface of the through openings 2T. Even when the cutting tables 2A, 2B are inverted front to back and laser light is irradiated from the another surface 2y, the laser light does not hit the inner surface of the through openings 2T. Thanks to this, not only can damage due to laser light hitting the cutting tables 2A, 2B be suppressed, but it is also possible to prevent the quality of the sealed substrate W from being reduced when reflected laser light hits an unintended area of the sealed substrate W.

### Other Embodiment Variations

Moreover, the present invention is not limited to the above-described embodiment.

The above-described embodiment is a cutting apparatus 100 which does bulk storage, but the invention is not limited to bulk storage, and storage may instead be as described below.

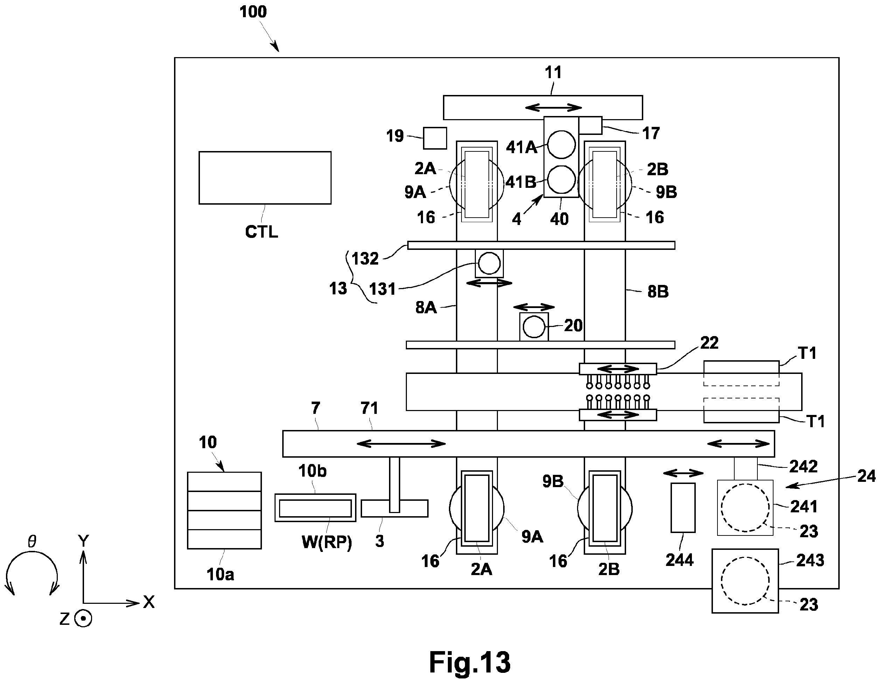

For example, as shown in FIG 13, the cutting apparatus 100 may also be one which stores a plurality of products P by attaching them to an affixing member 23 with an adhesive surface 23x (also called `ring storage') .

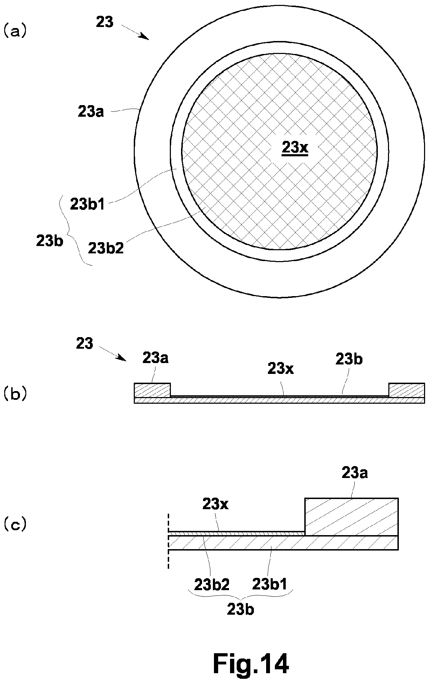

Specifically, as shown in FIG 14, the affixing member 23 includes a frame member 23a, which for example has a circular shape or rectangular shape, and a resin sheet 23b that includes an adhesive surface 23x, disposed on an inner side of the frame member 23a. The frame member 23a is made of metal, for example stainless steel. The resin sheet 23b, for example, includes a a sheet-shaped base material 23b1 made of resin and an adhesive layer (fastening layer) 23b2 made of adhesive applied to the upper surface of said sheet-shaped base material 23b 1. Moreover, the upper surface of the adhesive layer (fastening layer) 23b2 is the adhesive surface 23x.

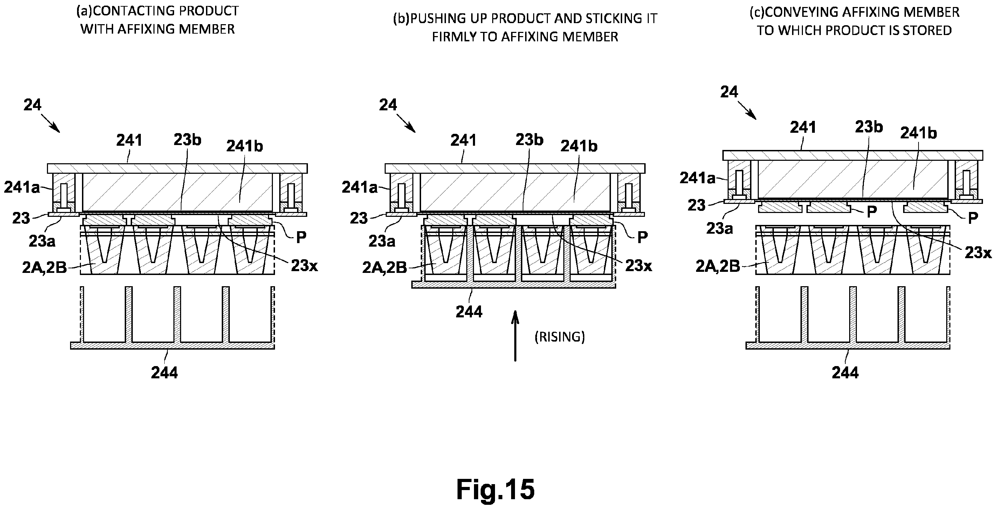

As shown in FIG 13 and FIG 15, the storage mechanism 24 causes the adhesive surface 23x of the affixing member 23 to contact a plurality of products P on the cutting tables 2A, 2B, directly storing them to the affixing member 23, which is the storage member.

Specifically, the storage mechanism 24 has an affixing member holding unit 241 that holds the frame member 23a of the affixing member 23 by suction, and an affixing-use conveying mechanism 242 that moves the affixing member holding unit 241 between an affixing member storage unit 243 and the cutting tables 2A, 2B. The affixing member holding unit 241 has a suction holding unit 241a that suctions and holds the frame member 23a and a buffer member 241b that contacts the adhesive surface 23x of the resin sheet 23b on its back surface side. When the storage mechanism 24 conveys the affixing member 23 to the cutting tables 2A, 2B, the cutting tables 2A, 2B are in a state of not being inverted front to back. Moreover, the affixing-use conveying mechanism 242 is configured using a transfer shaft 71, but a configuration without using a transfer shaft 71 is also possible.

Here, when the plurality of products P on the cutting tables 2A, 2B are made to adhere to the adhesive surface 23x of the affixing member 23, the products P may stick firmly to the cutting tables 2A, 2B and it may not be possible to reliably store the products P to the affixing member 23. For this reason, as shown in FIG 15, a pushing member 244 such as a pin may be used to push the back surface of the products P from the through opening 2T of the cutting tables 2A, 2B to separate them from the cutting tables 2A, 2B. The pushing member 244 is one that pushes the plurality of products P downward through the through openings 2T from above with respect to the cutting tables 2A, 2B that are inverted front to back.

Next, operation of a ring storage cutting apparatus 100 is explained. Up until the defective product removal process in the "Example of Operation of the Cutting Apparatus 100" embodiment above, it is the same.

### Storage Process

After removal of defective products, the cutting-use moving mechanisms 8A, 8B move the cutting tables 2A, 2B to a predetermined storage position (just before the transfer shaft 71). Moreover, the storage position of the present embodiment is the same as the conveying position to which the sealed substrate W is conveyed by the first holding mechanism 3, but it may also be a different position.

As shown in FIG 15, the cutting tables 2A, 2B in the storage position are in a state of not being inverted front to back. The affixing-use conveying mechanism 242 of the storage mechanism 24 then moves the affixing member holding unit 241, which holds the affixing member 23, to an affixing position located above the cutting tables 2A, 2B. Here, the affixing-use conveying mechanism 242 causes the adhesive surface 23x of the affixing member 23 held by the affixing member holding unit 241 to contact or be in proximity with the plurality of products P held by the cutting tables 2A, 2B. In this state, the suction hold of the cutting tables 2A, 2B is released, and the plurality of products P are pushed up through the through openings 2T by the pushing member 244. As a result, a plurality of products P are directly stored onto the affixing member 23 from the cutting tables 2A, 2B by sticking firmly to the adhesive surface 23X of the affixing member 23. After that, the affixing member 23 which stores the plurality of products P is conveyed to an affixing member storage unit 243 by the affixing-use conveying mechanism 242 and is stored.

Thus, also for the ring storage cutting apparatus 100 described above, the plurality of products P are directly stored to the affixing member 23 from the cutting tables 2A, 2B, so there is no need to separately convey the plurality of products P from the cutting tables 2A, 2B to another table or stage and then store them to the affixing member, simplifying the cutting apparatus 100 and improving productivity. The footprint of the cutting apparatus 100 can also be reduced thanks to being simplified. The effects of the ring storage cutting apparatus 100 are similar to that of the above-described embodiment.

Furthermore, the storage mechanism 21 of the above-described embodiment was configured to move the storage box 211 to the cutting tables 2A, 2B to directly store the plurality of products P in the storage box 211, but it is also possible to move the cutting tables 2A, 2B to the storage box 211 and directly store the plurality of products P in the storage box 211. The storage mechanism 21 may be configured to individually suction a plurality of products from the cutting tables 2A, 2B and directly store them in the storage box 211. Also for ring storage, a configuration is possible wherein the cutting tables 2A, 2B are moved to the affixing member holding unit 241, which holds the affixing member 23, and directly stores the plurality of products P to the affixing member 23. The storage mechanism 21 may be configured to individually suction a plurality of products from the cutting tables 2A, 2B and directly store them to the affixing member 23.

In the above-described embodiment, the camera moving mechanism 132 was used to move the inspection camera 131 in the direction of the cut (the X direction) to image of the plurality of products P held by suction to the cutting tables 2A, 2B; however, it is also possible for the cutting-use moving mechanism 8A, 8B to move the cutting tables 2A, 2B in the Y direction, to move in the direction of the cut, to image the plurality of products P suctioned to the cutting tables. Furthermore, it is also possible to image the plurality of products P held by suction to the cutting tables 2A, 2B while the camera moving mechanism 132 moves the inspection camera 131 and the cutting-use moving mechanisms 8A, 8B move the cutting tables 2A, 2B.

In the above-described embodiment, the inspection camera 131 was shared by the two cutting tables 2A, 2B, but it is also possible to provide one for each of the cutting tables 2A, 2B.

The above-described embodiment was configured such that the cutting tables 2A, 2B were moved from the cutting position to the inspection position and then inspection of the products P was carried out, but it also possible to carry out the inspection at the cutting position. In this case, the laser light irradiating units 41A, 41B may be moved away after the laser light irradiating units 41A, 41B of the cutting mechanism 4 finishes cutting, and the inspection camera 131 may then be moved to above the cutting tables 2A, 2B.

In the above-described embodiment, when the inspection camera 131 images the products P, the cutting tables 2A, 2B are in a state of not have been inverted front to back, but the cutting tables 2A, 2B may instead be in a state of having been inverted front to back. A configuration wherein the products P are imaged both before and after inverting the cutting tables 2A, 2B front to back is also possible.

In the two cutting tables 2A, 2B of the above-described embodiment, a plurality of through openings 2T were formed in the same position, but the plurality of through openings 2T may instead be formed in a plurality of cutting tables 2A, 2B at different positions from each other. In this configuration, after laser machining is done at one cutting table 2a, it may be changed over to another cutting table 2B, and laser machining may be carried out on another position of the sealed substrate W. Furthermore, two types of sealed substrates having different product layouts from each other may be respectively laser-machined using the two cutting tables.

As for the two cutting tables 2A, 2B of the above-described embodiment, it is also possible to provide three or more in order to balance the time required for each process.

It is also possible for the rotation mechanism of the cutting tables 2A, 2B to not be included, and instead the processing position can be rotated on the laser light irradiating unit side. In this case, when the first camera 131 is moved relative to the cutting tables 2A, 2B for inspection, the cutting tables 2A, 2B are not rotated and the cutting direction of the cut by the cutting mechanism 4 (the direction in which the kerf extends) and instead remain parallel to the Y direction.

The cutting apparatus 100 of the above-described embodiment was one which inverted the cutting tables 2A, 2B front to back and then cut the sealed substrate W, but it is also possible that, depending on the type of sealed substrate W or the like, the sealed substrate W can be cut from the front surface side only without inverting the cutting tables 2A, 2B front to back, or that the sealed substrate W be cut from the back surface side only by inverting the cutting tables 2A, 2B front to back.

The sealed substrates W of the above-described embodiment were such that the cutting lines CL1 and CL2 of the partition elements W1, W2 adjacent to each other were set on different straight lines, but it is also possible that the cutting lines CL1 and CL2 be set on the same straight line. In that case, the plurality of through openings 2T provided in the cutting tables 2A, 2B are provided on the same straight lines corresponding to the cutting lines CL1 and CL2. Here, the plurality of through openings 2T provided on the same line may be grouped together as a single through opening.

The cutting mechanism 4 of the above-described embodiment was configured to perform the cut using laser light, but a configuration which performs the cut with a blade is also possible.

The above-described embodiment was a twin cutting table system with two cutting tables, and was described as a cutting apparatus having a twin laser configuration with two laser light irradiating units, but it is not limited to this; also possible is a cutting apparatus that is a single cutting table system with one cutting table and a single laser configuration with one laser light irradiating unit, or a cutting apparatus that is a single cutting table system with one cutting table and a twin laser configuration with two laser light irradiating units, and so on.

In the above-described embodiment in FIG 7 and FIG 8, a configuration was shown in which the through openings 2T expand as they open from the one surface 2x to the another surface 2y over the entirety of the cutting tables (machining tables) 2A, 2B. However, it is not limited to this, as long as at least a portion of the through openings 2T are shaped so as to expand as they open from the one surface 2x to the another surface 2y. For example, a configuration is possible in which the through openings 2T are shaped so as to expand as they open from the one surface to the another surface only in the base plate 201 which is in the lowest position before the cutting tables 2A, 2B are inverted front to back.

In the above-described embodiment, full cut and half cut machining was described, but the machining conditions can be changed to others, and laser marking may additionally be performed.

The cutting apparatus of the present invention may be one which carries out machining other than cutting through the target, for example it may carry out a partial cut or grinding.

In additional, it goes without saying that the present invention is not limited to the above-described embodiments, and other variations are possible without departing from the intent of the invention.

### Industrial Applicability

According to the present invention, the machining apparatus can be simplified and its productivity improved.

### Explanation of Reference Signs

100: cutting apparatus (machining apparatus)
W: sealed substrate (machining target object)
P: product (machined product)
P': defective product
2A, 2B: cutting tables (machining tables)
2h: suction holes
2x: one surface
2y: another surface
2T: through openings
3: first holding mechanism (conveying mechanism)
4: cutting mechanism (machining mechanism)
41A. 41B: laser light irradiating units
7: conveying-use moving mechanism (conveying mechanism)
13: inspection unit
21: storage mechanism (bulk storage)
211: storage box
22: defective product removal mechanism
23: affixing member
23x: adhesive surface
24: storage mechanism (ring storage)

## Claims

1. A machining apparatus, comprising: a machining table provided on one surface thereof with a plurality of suction holes capable of holding a machining target object by suction, and that has a plurality of through openings which penetrate from the one surface to another surface,
a machining mechanism that machines the machining target object held by suction to the machining table, and
a storage mechanism that directly stores the machined machining target object from the machining table to a storage member.

2. The machining apparatus according to claim 1, wherein the machining table is able to be inverted front to back.

3. The machining apparatus according to claim 2, wherein the storage mechanism includes a storage box that stores the machined machining target object that falls from the machining table that has been inverted front to back.

4. The machining apparatus according to claim 1 or 2, wherein the storage mechanism causes an adhesive surface of an affixing member to contact the machined machining target object, which is on the machining table, and stores it onto the affixing member.

5. The machining apparatus according to any one of claims 1 to 4, wherein the storage mechanism includes a pushing member that pushes the machined machining target object from one of the through openings and separates it from the machining table.

6. The machining apparatus according to any one of claims 1 to 5, further comprising an inspection unit that inspects the machined machining target object held by suction to the machining table.

7. The machining apparatus according to claim 6, further comprising a defective product removal mechanism that removes the machined machining target object, which has been determined to be a defective product by the inspection of the inspection unit, from the machining table before it is stored to the storage member.

8. The machining apparatus according to any one of claims 1 to 7, wherein the machining mechanism cuts by irradiating laser light onto the machining target object.

9. The machining apparatus according to claim 8 citing claim 2, wherein the machining table holding the machining target object by suction is inverted front to back and cutting is performed by irradiating laser light onto both surfaces of the machining target object.

10. A method for manufacturing a machined product that manufactures the machined product using the machining apparatus according to any one of claims 1 to 9.

11. The method for manufacturing the machined product according to claim 10, including a cutting process wherein the machining table holding the machining target object by suction is inverted front to back, and the machining target object is cut by irradiating laser light onto both surfaces of the machining target object, and
a storage process in which the machined machining target object is directly stored from the machining table to a storage member.
